# EUROPEAN PATENT SPECIFICATION

(11) **EP 4 467 993 B1**
(45) Date of publication and mention of the grant of the patent: **25.06.2025**
(21) Application number: 23174590.2
(22) Date of filing: 22.05.2023
(51) Int. Cl.: G01R 19/25, G01R 15/18

(54) **DEVICE FOR ELECTRIC SYSTEMS**
VORRICHTUNG FÜR ELEKTRISCHE SYSTEME
DISPOSITIF POUR SYSTÈMES ÉLECTRIQUES

(43) Date of publication of application: 27.11.2024
(73) Proprietor: deZem GmbH, 10627 Berlin (DE)
(72) Inventor: RIEGEL, Georg, Berlin (DE); FRIEDRICH, Rick, 10627 Berlin (DE)
(74) Representative: Schmidt, Christian

(56) References cited:
- EP-A1- 2 731 220
- US-A1- 2010 161 263
- US-A1- 2012 081 104
- US-A1- 2016 091 548
- US-A1- 2020 251 927
- US-A1- 2021 109 136
- US-A1- 2022 146 557
- US-B1- 11 381 084

## Description

### Background

The present disclosure relates to a device for an electric system, e.g. a device for monitoring an electric system, such as the electricity parameters in the system.

Monitoring electric systems becomes increasingly important, e.g. with respect to power consumption.

Patent document US2021109136A1 introduces an intelligent electronic device that uses wireless current sensors to monitor each phase of a power line of a three-phase electric power delivery system. Said intelligent electronic device comprises a transceiver for receiving current measurements from wireless current sensors, and a processor which synthesizes the voltage of one phase based on the measured voltage of another phase.

Patent document US2020251927A1 introduces a measurement apparatus for sensing the parameters of a power transmission line. Said measurement apparatus comprises sensors for sensing the voltage/ current of the transmission line as well as a converter for harvesting energy from the transmission line and storing it in an energy storage unit.

### Summary

It is an aim of the present disclosure to provide an improved device for an electric system, e.g. for monitoring an electric system. The device may be particularly versatile and/or easy to use, for example. This aim is achieved by the subject-matter defined in the independent claim.

Advantageous embodiments are subject-matter of the dependent claims.

An aspect of the present disclosure relates to a device for an electric system, e.g. a device for monitoring the electric system. The device may be configured to monitor the momentary (or instantaneous) current, the momentary (or instantaneous) voltage and/or quantities or data derivable from the momentary values. These may be comprised by the electricity parameters monitorable or monitored by the device. The device may comprise a plurality of signal inputs. Each signal input of the plurality of signal inputs may be configured to receive or receive an electric signal associated with the electric system, e.g. at a specific time, and/or indicative of the momentary state of the electric system at a specific time (or a point in time).

By way of the plurality of signal inputs a plurality of signals may be provided to the device, e.g. from different signal providers or sources. Thus, one device may be used to process and/or evaluate a plurality of signals.

According to the invention, the device comprises a processing unit, e.g. an ASIC or a microcontroller.

The processing unit may be an electronic unit, e.g. a unit specifically configured for performing the functions described herein (in other words: the processing unit may be different from a general purpose processing unit such as a central processing unit, CPU, in a personal computer). The processing unit may be configured to perform a determining operation. In the determining operation, a signal value may be determined, e.g. measured. Signal values of signals received at one of, more of or all of the signal inputs may be determined in the determining operation. The (e.g. respective) signal value may be indicative of the momentary state (e.g. of the electric state) of the electric system (e.g. of a portion of the system) at the specific time (e.g. that time when the signal values are received in the device). The respective signal value may be a voltage signal value, e.g. indicative of the momentary voltage in a conductor of the electric system, or a current signal value, e.g. indicative of a momentary current in a conductor of the electric system. Signal values of the signals received at the respective inputs may be determined synchronously. Hence, a set of signal values may be indicative of the momentary state of the electric system, e.g. in different conductors of the system, such as at different phase conductors in a multi-phase alternating current system, or in one or more conductors of the same phase of the system but at different locations in the electric system.

According to the invention, the electric system is an alternating current system. "Alternating current system" expediently encompasses systems with alternating current and/or alternating voltage. The voltage or current may vary periodically, e.g. in a sinusoidal manner or in another manner.

According to the invention, the electric system is a multi-phase alternating current system, e.g. a three-phase alternating current system.

According to the invention, the processing unit is configured to perform a simulation operation. The simulation operation may simulate a signal value based on a signal value determined in the determining operation (which may be a measured signal value). The simulation operation may use the signal value determined by the processing unit, the determined signal value being indicative of the momentary state of one phase of the multi-phase alternating current system, e.g. at the specific time, to simulate a signal value indicative of the momentary state of another phase of the multi-phase alternating current system, e.g. at the specific time. The simulation may reduce the number of determining operations and/or may reduce the number of signals required to be analyzed to determine the momentary state of the electric system.

In an embodiment, alternatively or additionally to the simulation operation, the processing unit may be configured to perform a signal processing operation or signal calculation operation. This operation may process a signal received by the device via one of the inputs or ports before the processed signal value of this signal is used for calculating data (e.g. in the (data) calculation operation discussed further below). The processing unit may be configured to perform the signal processing operation or signal calculation operation before the determining operation or after the determining operation. The signal processing or signal calculation operation may comprises an integration, e.g. a time integration of a signal received via an input or port or a time-signal characteristic determined in the determining operation, or adding a time offset (e.g. corresponding to a phase shift of 90° at the characteristic frequency of the alternating current). The integration and/or the phase shift may be used to convert a voltage signal or voltage signal value into a current signal or current signal value (e.g. at the same specific time). In this case, the signals may be signals of the same phase. Integration may be preferable over merely adding the time offset as integrating may also consider higher harmonics when converting the voltage signal into the current signal (with the current signal value being which should be determined by the processing unit).

In an embodiment, the inputs of the device are configured to, e.g. each input of the device is configured to, accept voltage signals and/or current signals.

In an embodiment, the device comprises two, three, or four inputs. For multi-phase alternating current systems, three or more than three inputs are particularly advantageous.

In an embodiment, the plurality of inputs comprise a first signal input. The first signal input of the plurality of signal inputs may be configured to receive or receive a first signal indicative of a momentary (or instantaneous) first current of a first phase of a multi-phase alternating current in a first conductor.

In an embodiment, the plurality of inputs comprise a second signal input. The second signal input may be configured to receive or receive a second signal. The second signal may be indicative of a momentary (or instantaneous) second current of a second phase of the multi-phase alternating current in a second conductor. Alternatively, the second signal may be indicative of a momentary (or instantaneous) second current of the first phase of the multi-phase alternating current in the first conductor (but expediently at a different location of the electric system than the first signal).

In an embodiment, the plurality of inputs comprise a third signal input. The third signal input may be configured to receive or receive a third signal. The third signal may be indicative of a momentary (or instantaneous) third current of a third phase of the multi-phase alternating current in a second conductor. Alternatively, the third signal may be indicative of a momentary (or instantaneous) third current of the first phase of the multi-phase alternating current in the first conductor (but expediently at a different location of the electric system than the first and second signals).

In an embodiment, the plurality of inputs comprise a further signal input, e.g. a fourth signal input. The further signal input may be a voltage signal input. The voltage signal input may be configured to receive a voltage signal. The voltage signal may be indicative of a momentary first voltage of the first phase of the multi-phase alternating current at or in the first conductor. The voltage signal may be tapped directly from the first conductor and/or be acquired without an inductive coupling. This facilitates using the voltage to provide energy for the operation of the device.

In an embodiment, in the determining operation, signal values based on or indicative of the signals received at all or some of the inputs may be determined or measured simultaneously or in a synchronized manner by the processing unit, e.g. at the specific time. For example, first, second and/or third current signal values may be determined. The first current signal value at the specific time may be determined, e.g. measured, based on the first signal at the specific time. The second current signal value at the specific time may be determined or measured, based on the second signal at the specific time. The third current signal value at the specific time may be determined or measured, based on the third signal at the specific time. The signal values may be indicative of the momentary first current in the first conductor at the specific time (first current signal value), of the momentary second current in the second conductor at the specific time (second current signal value) and/or of the momentary third current in the third conductor at the specific time (third current signal value).

In an embodiment, in the determining operation, a first voltage signal value (i.e. a voltage signal value of the first voltage) at the specific time is determined, e.g. measured. The first voltage signal value may be based on or indicative of the voltage signal (e.g. of the first voltage) at the specific time.

In an embodiment, in the simulation operation, a second voltage signal value is simulated. The second voltage signal value may be indicative of a momentary second voltage of the second phase of the multi-phase alternating current at the specific time at or in the second conductor. The second voltage signal value may be simulated based on the first voltage signal value at the specific time.

In an embodiment, in the simulation operation, a third voltage signal value is simulated. The third voltage signal value may be indicative of a momentary third voltage of the third phase of the multi-phase alternating current at the specific time at or in the third conductor. The third voltage signal value may be simulated based on the first voltage signal value at the specific time.

Simulating the second and/or third voltage signal values based on the first voltage signal value may avoid that a second or third conductor of the multi-phase alternating current system has to be tapped or tampered with by an operator or user. This may improve usability and increase user safety considerably. The first, second and/or third voltage signal values may be indicative of the phase voltage (e.g. the potential difference to the neutral conductor of a three-phase alternating current system).

In an embodiment, simulating the second voltage signal value (or the time-voltage characteristic of the second voltage) and/or simulating the third voltage signal value (or the time-voltage characteristic of the third voltage) comprises using a time-voltage characteristic of the first voltage (or of the one with the measured voltage signal value). The time-voltage characteristic of the first voltage may be based on first voltage signal values previously determined by the processing unit, e.g. at earlier specific times. The required number of values may be stored in a memory of the device, preferably only temporarily.

In an embodiment, simulating the second voltage signal value and/or the third voltage signal value may comprise shifting the time-voltage characteristic of the first voltage (which may be formed by the first voltage signal values) by an offset. The offset may be a time corresponding to or determined by a phase offset (and preferably a characteristic frequency), e.g. between two successive phases of the multi-phase alternating current system, such as between the first phase and the second phase. The phase offset may be determined by, e.g. equal to, the phase angle between two phases, e.g. two successive phases, of a three-phase alternating current system. The phase offset may be, for example, 120°, - 120°, or 240°. The phase angle may be different for the second and third voltage signal values, e.g. 120° for the second voltage value and -120° or 240° for the third voltage signal value.

In an embodiment, the offset (e.g. the respective offset) is constant or variable.

In an embodiment, the device, e.g. the processing unit, is configured to determine the offset, e.g. dynamically. The simulation operation may be based on the dynamically determined offset. The offset may be determined based on the time-voltage characteristic of the first voltage and/or based on a, preferably momentary, first voltage frequency. The momentary first voltage frequency may be characteristic for the first voltage currently at the first conductor. The momentary frequency may deviate from a nominal frequency, which may be 50 or 60 Hz, of the respective phase. The frequency may be the oscillation frequency of the, e.g. sinusoidal, oscillation of the alternating current or voltage of the first phase. The processing unit may take a representative portion of the time-voltage characteristic of the first voltage (e.g. based on first voltage signal values determined directly before the offset is determined, such as a portion with a length of one oscillation cycle or more) and determine the momentary characteristic frequency from that portion (e.g. by averaging if more than one cycle is used). The momentary characteristic frequency may be determined by the processing unit, e.g. using the Goertzel algorithm. The offset may be adjusted to the determined momentary characteristic frequency, expediently based on the constant phase offset or phase angle between the phases.

In an embodiment, the device is configured to perform the determining operation with a determining frequency. The determining frequency may be greater than a characteristic frequency of an alternating current system, e.g. the multi-phase alternating current system. The characteristic frequency may be 50 Hz or 60 Hz. The determining frequency may be greater than N-times the characteristic frequency. N may be greater than or equal to any one of 10, 20, 30, 40, 50, 60, 70, 80 and/or N may be less than or equal to any one of 150, 140, 130, 120, 110, 100, 90, 80. Alternatively or additionally, the determining frequency may be between 1 kHz and 10 kHz, e.g. between 1 kHz and 7 kHz or between 2 kHz and 6 kHz. The upper and lower limits may be included in the respective ranges

Thus, for every oscillation cycle of current and/or voltage, e.g. in the phases of the multi-phase alternating current system, there may be a huge number of specific times at which signal values are determined by the processing unit, each specific time corresponding to one determining event or operation performed by the processing unit.

In an embodiment, the device comprises a memory. The memory may be configured to store signal values (determined or measured ones and/or simulated ones), the associated specific time, and/or data derived from the signal values, e.g. in the calculation operation which is described further below.

In an embodiment, the multi-phase alternating current is a three-phase alternating current with a phase offset between any two successive phases of 120°. Each phase may be formed by an alternating current and voltage.

In an embodiment, the signal inputs of the plurality of signal inputs, e.g. the first signal input, the second signal input and/or the third signal input or the further signal input, are configured to be connected to or are connected to an associated signal provider, e.g. by way of a wired connection. The signal provider may provide the interface to the conductor of the electric system. The coupling of the signal provider to the conductor may be wired or wireless, e.g. inductively.

In an embodiment, the plurality of signal inputs, e.g. the first signal input, the second signal input, the third signal input, and/or the further signal input, are configured to receive one of, an arbitrarily selected plurality of or all of the following signals or signal types:
- voltage signals, e.g. indicative of a current or indicative of a voltage,
- current signals, e.g. indicative of a current,
- analog signals, such as
   - DC signals, and
   - AC signals.

The signals may be provided to the respective input by a signal provider, which is coupleable or coupled to an associated input.

In an embodiment, the respective signal provider is or comprises one of:
- a current transformer,
- a Rogowski coil,
- a resistor, such as a shunt resistor.

All of these signal providers may be used to provide signals indicative of the momentary current or voltage in or of the associated conductor. Current transformers and Rogowski coils may be inductively coupled to the associated conductor of the electric system. Shunt resistors may be coupled to the associated conductor of the electric system by a wired connection or coupling. The shunt resistor may be used to provide a voltage signal, e.g. an AC signal, indicative of the voltage, e.g. the phase voltage versus a neutral conductor, or a voltage signal indicative for a current, e.g. for a DC current.

In an embodiment, the device has a device housing. The device housing may define the exterior of the device. The device housing may house all electronic and/or electric components of the device. The device housing may have an interior. A volume of the interior (e.g. the volume of the free space delimited by the device housing if the interior is empty) may be less than or equal to 100 cm³ and/or greater than or equal to 10 cm³. The volume of the interior of the device housing may be less than or equal to 80 cm³ and/or greater than or equal to 20 cm³.

Thus, the device can be very compact which increases the flexibility of the location where the device can be placed while it monitors the electric system, e.g. close to the location (such as less than 1 m from the location) where the signal provider(s) is(are) coupled to the electric system, e.g. to associated conductor(s).

In an embodiment, the processing unit is configured to perform a calculation operation. In the calculation operation, data characteristic for the electric system, e.g. the multi-phase alternating current system, may be calculated. The data may be characteristic for the actual state of the electric system e.g. at the specific time.

The data characteristic for the electric system calculated in the calculation operation may comprise data calculated based on one or more signal values determined in the determining operation, e.g. data calculated only based on determined or measured signal values (this data may be based only on determined or measured signal values, i.e. without using simulated signal values), and/or data calculated based on one or more signal values determined in the determining operation and one or more signal values simulated in the simulation operation. The data for the first phase may use only measured or determined signal values. The data for the second and third phases may use data based on measured and simulated signal values.

The data characteristic for the electric system may be calculated based on the signal value at the specific time or based signal values in a defined determining interval, where the calculation may involve averaging (e.g. by an RMS averaging procedure).

For example, the data characteristic for the electric system, e.g. the multi-phase alternating current system, may be calculated based on any one of, any arbitrarily selected plurality of or all of the following signal values:
- the first current signal value at the specific time or first current signal values in a defined determining interval,
- the second current signal value at the specific time or second current signal values in a defined determining interval,
- the third current signal value at the specific time or third current signal values in a defined determining interval,
- the first voltage signal value at the specific time or first voltage signal values in a defined determining interval,
- the second voltage signal value at the specific time or in a defined determining interval,
- the third voltage signal value at the specific time or third voltage signal values in a defined determining interval.

Here, the second and/or third voltage signal values may be simulated values.

In an embodiment, the data characteristic for the electric system, e.g. the (optionally multi-phase) alternating current system, comprises any one of, any arbitrarily selected plurality of or all of:
- active load,
- active energy,
- reactive load,
- reactive energy,
- apparent load,
- apparent energy,
- power factor,
- voltage frequency (e.g. the oscillating frequency),
- current frequency (e.g. the oscillating frequency).

This data may be calculated in the calculation operation. The data may be calculated for each phase of the multi-phase alternating current system.

In an embodiment, the device is configured such that the determining operation, the simulation operation, and/or the calculation operation is carried out to provide signal values and/or data at different times to enable a time-resolved monitoring of the electric system, e.g. one phase, more than one phase or all phases of the multi-phase alternating current system.

In an embodiment, the device comprises a wireless transmission unit. The wireless transmission unit may be operable to transmit data characteristic for the electric system, e.g. the multi-phase alternating current system. The data may be data previously calculated in the calculation operation. The transmission unit may transmit the data to a gateway. The transmission unit is expediently configured to transmit data with low power over a long range. The wireless connectivity interface for the transmission unit may be a LoRaWAN interface, where other wireless transmission protocols or technologies can be employed as well.

The transmission unit may transmit calculated data, such as data characteristic for the state of the electric system, signal values and/or messages, e.g. about the state of the device, to a receiver, e.g. via the gateway. The receiver may be a computing device.

According to the invention, the device comprises an energy harvesting unit. The unit may be configured to harvest electrical energy, e.g. from signals received by the one or more of the signal inputs or from the conductors. The harvested energy may supply energy for the operation of the device, e.g. to power the processing unit for the determining operation, the simulation operation, the calculation operation and/or to power the wireless transmission unit.

In an embodiment, the device may be operated as or may be a self-sustainable device. No separate energy source which is preloaded with energy may be required to operate the self-sustainable device. Alternatively or additionally, the device may be free of a connector for the connection to an external power supply.

In an embodiment, the device comprises a switching unit. The switching unit may be operable to switch transfer of signals received by the device via the inputs between the processing unit and the energy harvesting unit or a combination of both. Hence, the signals may be used for the determining operation or for energy harvesting or both. The switching unit may be configured such that signals received via each input can be switched independently between being transferred to the processing unit and the energy harvesting unit or a combination of both. This increases the flexibility of the device.

According to the invention, the device has an energy storage unit. The energy storage unit may be configured to store harvested energy.

In an embodiment, the device is free of a separate power source. The device may be energy self-sufficient.

In an embodiment, the device is configured to be operable using only energy provided to it via a signal current or by the energy harvesting unit.

In an embodiment, the device has an energy monitoring unit, e.g. for the energy storage unit. The energy monitoring unit may be configured to monitor, whether
i) sufficient energy is provided via the energy harvesting unit, e.g. to the energy storage unit, and/or whether
ii) sufficient energy is available (e.g. via a voltage of the electric system used to supply energy), and/or whether
iii) sufficient energy is stored in the energy storage unit
to continue operation of the device, e.g. of the processing unit and/or the transmission unit. If the energy monitoring unit detects that insufficient energy is provided, available, and/or stored, the device may be configured to adapt its operation or change operation parameters, e.g. to reduce energy consumption. The processing unit may control the device to adapt its operation or change operation parameters. Adapting the operation may include lowering the determining frequency and/or lowering a frequency of data transmission events and/or transmitting a message signaling the shortage or the potential shortage in energy, e.g. to a gateway or a computing device (such as the device to which the generated data is transmitted and/or evaluated).

In an embodiment, the device is configured such that the determining operation, the simulation operation, and/or the calculation operation are carried out, e.g. at successive and/or regularly spaced points in time, with a frequency of greater than or equal to a characteristic frequency of the system, e.g. the oscillation frequency of the alternating current(s) of the system.

In an embodiment, the device comprises an analog-digital converter. The converter may be configured to sample analog signals received by the device via the signal inputs synchronously and/or at a sampling frequency which is greater than or equal to the determining frequency.

In an embodiment, digital signals are provided from the analog-digital converter to the processing unit.

In an embodiment, the device is configured to monitor electricity parameters, e.g. comprising the data mentioned above and/or below, in the multi-phase alternating current system, e.g. the current and/or electrical power in the system. The device may be configured to monitor different phases of the multi-phase system.

In an embodiment, the device has an average power consumption of less than or equal to 0.25 mW per signal input or per active signal input (i.e. signal inputs provided with signals).

In an embodiment, the device has an average total power consumption of less than or equal to 1 mW.

According to the invention, a device for an electric system is provided, the device comprising:
a plurality of signal inputs, wherein each signal input of the plurality of signal inputs is configured to receive a signal associated with the electric system and indicative of the momentary state of the electric system at a specific time, and
a processing unit, wherein
the processing unit is configured to perform a determining operation, wherein, in the determining operation, a signal value of the signal received at one of, more of or all of the signal inputs is determined, e.g. measured, the determined signal value being indicative of the momentary state of the electric system at the specific time.

Another aspect of the disclosure relates to machine-readable instructions, e.g. stored in non-volatile memory, which, when executed by a processing unit control operation of the device as described above or below. The instructions may be software or firmware. The disclosure also relates to a data carrier comprising such instructions stored on the data carrier.

Features described above and below in connection with different aspects or embodiments may be combined with one another.

### Brief description of the drawings

Figures 1A to 1C illustrate an embodiment of a device in accordance with the present disclosure.
Figure 2 illustrates an embodiment of the device of the present disclosure for a three-phase alternating current system.

### Description of exemplary embodiments

Identical features, features of the same kind, identically or similarly acting features may be provided with the same reference numerals in the drawings. Further, it is noted that the drawings are schematic drawings and may not be true to scale. The drawings are provided to facilitate a better understanding of the concepts described herein.

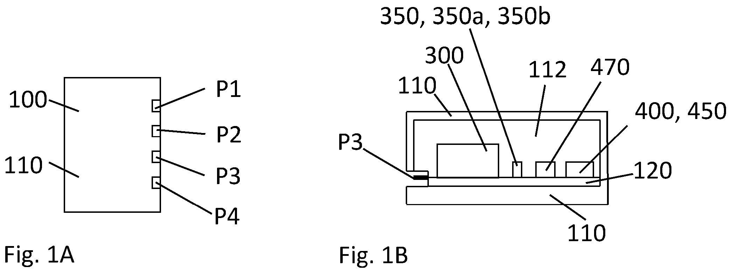

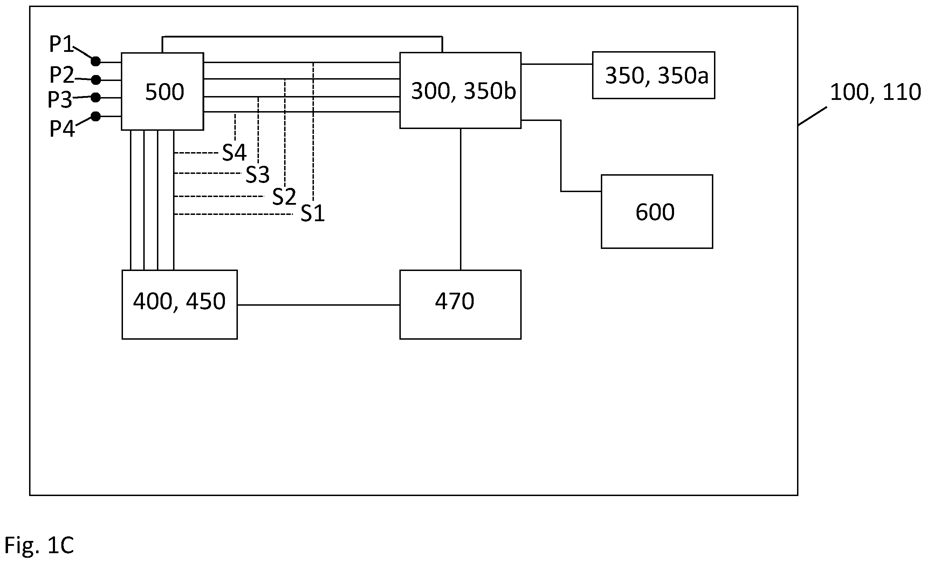

Figure 1A schematically illustrates a top view onto an embodiment device 100 from the exterior. Figure 1B illustrates a schematic sectional view of the device 100 and figure 1C some units and functionalities of the device 100.

The device 100 is a sensor device. The device is configured to be used for an electric system. The device 100 can be used to determine, e.g. to continuously monitor, data characteristic for the electric system and/or to acquire electric signals from which the data can be determined. The device 100 has a housing 110. In the interior 112 of the housing 110, one or more electrical or electronic components of the device 100 may be arranged and expediently operatively coupled to one another to provide the functionalities of the device 100. A conductor carrier 120 (see figure 1B), e.g. a circuit board, such as a printed circuit board, can couple the components electrically to one another. The housing can have or define an interior volume of less than or equal to one of the following: 100 cm³, 90 cm³, 80 cm³, 70 cm³, 60 cm³, 50 cm³, 40 cm³, 30 cm³. Alternatively or additionally, the interior volume may be greater than or equal to: 5 cm³, 10 cm³, 15 cm³, 20 cm³, 25 cm³. The device 100 can be provided with a particularly small exterior footprint as the interior space required for the electronic functionality is comparatively small. This makes the device easy to use or apply in situations where there is not much space to position the device, e.g. close to conductors of an electric power grid. The exterior footprint of the device, e.g. the area of the largest exterior surface of the housing 110, may be less than or equal to one of the following: 50 cm², 40 cm², 30 cm².

The device 100 can be or can be operated as a self-sustainable device or, in other words, a device which does not need (and does not have) a separate energy source to power the device during its operation. Rather, the energy required for the operation of the device 100 may be derived from signals provided to the device for determining a characteristic of the electric system and/or from the electric system itself, e.g. via an inductive coupling. As will be discussed in more detail below, the device 100 expediently comprises an energy harvesting unit to harvest energy from signals characteristic for the state of the electric system and/or the device can draw the power required for its operation directly from the electric system.

The electric system may be or may comprise a power grid and/or an electric load or electric consumer, e.g. within the power grid. The electric system may be a direct current system or an alternating current system. The system may be a or may be comprised by a multi-phase alternating current system such as a three-phase alternating current system. The frequency with which the alternating current system is operating (e.g. the oscillating frequency of the alternating voltage or current, e.g. for each phase) may be 50 Hz or 60 Hz, for example. The device may be provided to determine the characteristic of the electric system at a particular location of the system, e.g. close to the electrical load or close to a location which is characteristic for the power grid, e.g. close to the power source or the power input of the power grid, such as the power input into the power grid of a building ("close" in this context may mean a location before the first load or consumer is connected to the power input). Different electric loads or consumers in a power grid or different locations in a power grid may be provided with different devices 100. Hence, different electric loads, consumers, phases and/or locations (e.g. in different phases or in the same phase) may be monitored by different devices 100, e.g. with respect to characteristics, such as power consumption or other characteristics, for example.

The device 100 has a plurality of signal inputs or ports P1 ... P4. In the depicted embodiment, the device has four inputs or ports. The respective input or port may be or may comprise a connector, such as a plug-in connector, e.g. a male or female connector. The respective input or port may serve as an interface between the device and a signal provider, which can be or is coupled to the device via the respective input or port P1 ... P4.

The device 100 can receive different signals at different inputs. The respective signal can, for instance, be an analog signal. The signals may be processed internally in the device 100. Having a plurality of inputs in the device makes the device very versatile. The device may be configured to receive different signals or signal types via the respective input or port P1 ... P4. The signals of the different types may be processed in the device 100. The device is expediently configured to process the signals received via the inputs or ports synchronously.

The device 100 can be configured to receive any one of, any arbitrarily selected plurality of, or all of the following signals or signal types via one of the inputs or ports, via any arbitrarily selected plurality of the inputs or ports or via all of the inputs or ports P1 ... P4:
- DC (DC: direct current) signals, e.g. DC voltage signals and/or DC current signals. Typical DC signals may be 4 mA to 20 mA for currents or 0V to 10V or 0.1 V to 10 V for voltages. The signals may comprise voltage signals from load cells or signals typical for industry standards such as current signals of 0-20mA or 4-20mA or voltage signals of 0-5V or 0-10V.
- AC (AC: alternating current) signals, e.g. AC voltage and/or AC current signals, e.g. raw signals from Rogowski coils, preferably without need for an integrator (see further below).
- voltage signals indicative of a current, e.g. for a DC current or an AC current. These signals may be DC signals for a DC current or AC signals for an AC current, for example.
- voltage signals indicative of a voltage, e.g. a DC voltage or an AC voltage. These signals may be DC signals for a DC voltage or AC signals for an AC voltage. At least one of or all of the inputs or ports may be configured to be directly supplied with a voltage, e.g. with a voltage of one phase of a multi-phase alternating current system. This voltage may be used to provide the energy necessary for the operation of the device 100. The energy harvesting unit (which is described in more detail below) may provide a backup power supply, in case the voltage ceases.
- current signals indicative of a current, e.g. a DC current or an AC current. These signals may be DC signals for a DC current or AC signals for an AC current.

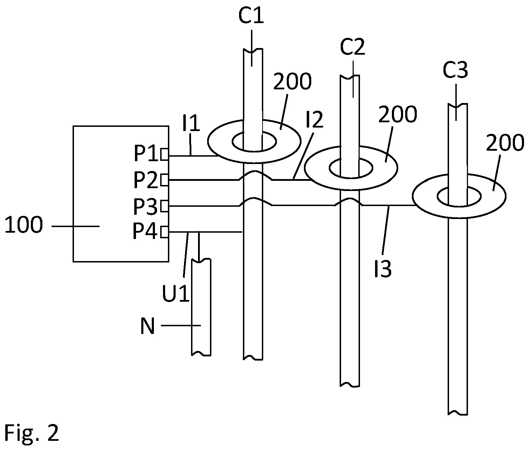

The signals may be provided to the respective input or port P1 ... P4 by a signal provider 200. Such a signal provider is not shown in Figures 1A to 1C (see Figure 2 for an example for such a signal provider 200). The signal provider 200 may provide a link to or an interface with the electric system which should be monitored by the device 100. For example, the signal provider may be electrically coupled, e.g. wirelessly or wired, to the electrical system, such as to a conductor thereof. In one embodiment, the coupling may be a wired coupling. In other embodiments, the coupling may be wireless, e.g. an inductive, coupling. The respective signal provider 200 may be, expediently releasably, coupled to the respective input or port P1 ... P4. Each input or port may be configured to be coupled with different signal providers. Thus, a large variety of different signals can be fed to the device via the respective inputs or ports. Of course, it is also possible to permanently or irreleasably couple a particular signal provider with the respective input or port. The respective signal provider 200 may be a passive electric component.

The respective input or port P1 ... P4 can be used with any one of, any arbitrarily selected plurality of, or all of the following signal providers:
- a current transformer; current transformers are suitable to be inductively coupled to a conductor and/or to provide current signals, particularly AC current signals, indicative of a current flowing through the conductor. The current flowing in the current transformer may be induced by the current flowing through the conductor.
- a Rogowski coil; Rogowski coils usually provide voltage signals, particularly AC voltage signals, which are indicative of the time derivative of a current flowing through a conductor associated with the coil, e.g. passing through the coil. The voltage signal may be related to, e.g. proportional to, the rate of change of the current in the conductor associated with the Rogowski coil. As opposed to regular current transformers using Rogowski coils entails a variety of advantages. For example, Rogowski coils usually have a low inductance and, consequently, are suitable for fast-changing currents. Also, production costs are low.

However, if the waveform of the AC current should be obtained, usually an integrator is needed to reproduce the current waveform due to the phase shift (usually 90°) of the voltage waveform relative to the current waveform. In the presently proposed device such an integrator is not needed owing to the simulation functionality which the device preferably has and which is described in more detail further below.
- A signal provider comprising a resistor, e.g. a shunt resistor. The resistor may provide a voltage signal indicative of a current. A shunt resistor may be a resistor used for measuring currents, e.g. via a voltage drop at the resistor. Usually, resistors or shunt resistors for measuring currents via voltage drops at the resistor have a low resistance, e.g. less than 100 micro-ohm or less than 50 micro-ohm.

The respective signal provider 200 may provide raw signals or non-processed signals, e.g. signals which not yet have been subject to active signal processing steps, such as amplification, differentiation, and/or integration, for example. Signal processing, e.g. the entire signal processing, may be done in the device 100 after the signals have been received in the inputs or ports P1 ... P4.

The signals may provide, e.g. continuous, information about the momentary state of the electric system. That is to say, if the device determines or measures the values of the signals at a specific time or instance, these signal values indicate the current or momentary state of the electric system, e.g. the momentary current or momentary voltage at a specific location of the system and/or of a phase of the system. The device 100 may enable simultaneously monitoring of four different signals expediently in a synchronous manner. Measurements are or can be expediently taken at a frequency which is between 1 kHz and 7 kHz or between 2 kHz and 6 kHz. This facilitates monitoring of electricity in the electric system.

Figure 1C schematically illustrates units of the device and their interrelation. The units may be implemented by using electric or electronic components provided in the interior 112 of housing 110.

The device 100 comprises, for example, any one of any arbitrarily selected plurality of or all of:
- a processing unit 300. The processing unit 300 may comprise one or more electronic components, e.g. microcontrollers or ASICs (ASIC: application specific integrated circuit) such as the component STM32WLE5CCU6 available from STMicroelectronics. The functionalities described herein for the processing unit 300 may be implemented by one electronic component, e.g. the STM component, or a plurality of electronic components, e.g. distributed over the conductor carrier 120. The functionalities may be implemented with a single electronic component, e.g. a single component mountable on the conductor carrier. Alternatively, the functionalities which are described herein for the processing unit may be implemented via a variety of electronic components, e.g. microcontrollers and/or ASICs. Expediently, the electronic component(s) is(are) disposed in the housing 110 and/or conductively connected to conductors of the conductor carrier 120.

The processing unit 300 may comprise separate inputs or ports for the signals. Thus, the signals may be received in and be processed by the processing unit separately or individually. Further details on the functionalities of the processing unit are set forth further below.
- a memory 350, e.g. a data memory 350a and/or a program memory 350b. The memory, particularly the data memory, may be used to store data, e.g. measured or determined signal values, the specific time associated with the signal value, and/or data derived therefrom. The memory, particularly the program memory 350b, may be used to store machine-readable instructions, which, when executed by the processing unit, cause the processing unit to control operation of the device 100, e.g. as described herein. The respective memory may be volatile (e.g. the data memory) or non-volatile (e.g. the program memory). The data memory and the program memory may be implemented in different components or in one component. For example, the program memory 350b may be part of the processing unit 300 or a separate memory and the data memory 350a may be implemented in a separate dedicated memory unit. The program memory may comprise firmware or software which, when executed by the processing unit 300, controls operation of the device 100, e.g. to operate as described herein above and below.
- an energy harvesting unit 400. The energy harvesting unit 400 may be configured to harvest energy from signals provided to the device via the inputs or ports P1 ... P4. The energy harvesting unit can harvest energy, for example from current signals. It is advantageous to harvest energy, e.g. when the signals are not needed for a determining or measurement operation or when it is more important to harvest energy (e.g. in case of a threatening energy shortage). The energy harvesting unit 400 may be operatively coupled or coupleable to each of the inputs or ports P1 ... P4 of the device 100. The inputs or ports may be individually and/or selectively coupled to the energy harvesting unit 400. Hence, the device 100, e.g. the processing unit 300, can decide whether a particular signal from a particular input or port should (e.g. at a specific time) be used for energy harvesting or be guided to the processing unit e.g. for the determining or measurement operation (or optionally even both). Hence, signals provided to the device via each of the inputs or ports P1 ... P4 can be used to harvest energy or be subject to measurements or a combination of both. The harvested energy can be used to operate the device 100 and/or be stored in an energy storage 450 of the device. The storage 450 may be part of the energy harvesting unit 400. The energy storage 450 may be or may comprise a capacitor, e.g. a supercapacitor, an electrochemical capacitor and/or an electrolyte capacitor.

The energy harvesting unit 400 may render a separate power source (e.g. a battery) pre-loaded with energy in the device 100 superfluous and enables a long-term deployment of the device at the desired location without the need of regular maintenance, e.g. for replacing or recharging a battery.
- a switching unit 500. The switching unit 500 is configured to switch signal transfer (or the transfer of energy provided by signals) of signals (denoted as S1 for a signal originating from port P1, S2 for a signal originating from port P2, S3 for a signal originating from port P3, and S4 for a signal originating from port P4) received by the device 100 via the ports P1 to P4 between the processing unit (expediently such that the signals can be processed by the processing unit, e.g. for measurement or determining operations) and the energy harvesting unit 400 (such that energy provided by the signals can be harvested). The switching unit 500 can switch signals from each of the ports or inputs P1... P4 individually. The switching unit 500 can be configured such that the entire signal may be transferred to either the processing unit or the energy harvesting unit or the entire signal, e.g. a current signal, is distributed between both units. It is preferred that the processing unit either receives the entire signal, e.g. the current signal, provided via an input or port or no signal at all, e.g. as receiving only a portion of the signal might yield incorrect measurement results.

The switching unit 500 can be operatively coupled to the processing unit 300. The processing unit may control the switching unit.

The switching unit 500 can be implemented as a multi-channel switching unit 500. One channel can be associated with and optionally be dedicated to each input or port P1... P4, each channel being switchable between being coupled to either the energy harvesting unit or the processing unit. Each channel may be configured to guide or transmit one of the signals S1 ... S4. The switching unit 500 may comprise one or more relays, expediently one for each channel or input or port. The one or more relays may be controlled and/or switched by the processing unit (e.g. between signal transfer to the processing unit or to the energy harvesting unit), expediently individually for each channel.
- an analog-digital converter (not explicitly shown). The converter may be positioned between the switching unit and the ports P1... P4 as seen along a signal path or between the switching unit and the processing unit. The converter may convert analog signals into digital signals. The converter is expediently configured to sample analog signals received by the device 100 via the signal inputs or ports P1... P4 synchronously and/or at a sampling frequency to provide digital signals. The sampling frequency is expediently greater than or equal to the determining frequency (see below). The sampling frequency can be greater than or equal to: 1 kHz, 2 kHz, 3 kHz, 4 kHz, 5 kHz, 6 kHz, 7 kHz, 8 kHz, 9 kHz, 10 kHz. Alternatively or additionally, the sampling frequency can be less than or equal to: 20 kHz, 15 kHz, 10 kHz, 8 kHz, 6 kHz, 4 kHz. The frequency may be between 1 kHz and 20 kHz. The digital signals output by the converter can be processed by the processing unit 300, e.g. to determine or measure the signal values. Signals from all inputs or ports P1... P4 may be sampled simultaneously and synchronously by the converter. The converter has expediently a number of separate channels greater than or equal to the number of inputs or ports P1 ... P4. This facilitates monitoring of the current state of the electric system. The (e.g. analog) signals are preferably sampled individually.

In some embodiments, the device comprises one or more internal resistors, e.g. shunt resistors. The respective resistor may be positioned in the signal path before the analog-digital converter, e.g. between the switching unit and the processing unit and/or between the analog-digital converter and the switching unit 500. The respective resistor may be suitable to convert a current signal into a voltage signal which can be processed further by the analog-digital converter. One resistor may be assigned to each input or port P1 ... P4 or each of the signal paths from the inputs or ports to the processing unit 300.
- a transmission unit 600. The transmission unit may be configured to transmit data, e.g. data determined or calculated by the device 100 (e.g. data characteristic for the electric system, see further below) to other entities, e.g. a gateway or a computer. The transmission unit 600 expediently is a wireless transmission unit. The transmission unit may provide a wireless network interface. A wireless network interface as described herein may be equipped with typical wireless network connectivity technologies, such as, for example, Wireless Personal Area Network (WPAN) technologies (e.g., IrDA, Bluetooth, IEEE 802.15.4a (Zigbee), and IEEE 802.15.3c (UWB)), Wireless Local Area Network (WLAN) technologies (e.g., IEEE 802.1 1 a/b/g (Wi-Fi), proprietary MIMO products, and IEEE 802.1 1 η), Wireless Metropolitan Area Network (WMAN) technologies (e.g., IEEE 802.16 Broadband Wireless Access WMAN standard (WiMAX) and IEEE 802.20 (Mobile WiMAX)), and Wireless Wide Area Network (WWAN) technologies (e.g., LoRaWAN, GSM/GPRS/EDGE, CDMA2000, 1 xRTT, UMTS/HSDPA, LTE, CDMA EV-DO Rev.0/A, HSUPA and EV-DO Rec.C, satellite, sonar/sound, Z-wave, Sigfox, LP WAN, and so forth).

In terms of low power consumption and long range, LoRaWAN has proven to be particularly advantageous.
- a receiving unit (not explicitly shown). The receiving unit may be wired or wireless. The receiving unit may be provided to receive configuration data or setup data for defining how the device operates in a given operation setting. The configuration or setup data may include data which indicates, for example:
   - whether a simulation operation should be performed in the particular operation setting (see further below),
   - which inputs or ports are provided with associated signals in the operation setting.

The receiving unit may receive software and/or firmware updates for the device 100.
- an energy monitoring unit 470. The energy monitoring unit 470 may be integrated into the processing unit 300 or be a separate unit. The energy monitoring unit 470 may be operatively coupled to the energy harvesting unit 400 and/or to the energy storage unit 450. The energy monitoring unit 470 may be configured to monitor energy harvested by the energy harvesting unit and/or energy stored in the energy storage, e.g. how much energy is harvested currently by the energy harvesting unit 400 and/or how much energy is currently stored in the energy storage 450.

The energy monitoring unit 470 can be configured to monitor whether
i) sufficient energy is provided via or to the energy harvesting unit (e.g. energy sufficient to operate the device and/or charge the energy storage) and/or whether
ii) sufficient energy is stored in the energy storage unit
to continue operation of the device 100, e.g. the operation of the processing unit 300 and/or the transmission unit 600. If the energy monitoring unit detects that insufficient energy is provided and/or stored, the device 100 is configured to adapt its operation to reduce energy consumption, expediently under control of the processing unit 300 and/or of the energy monitoring unit 470. Adapting the operation may include lowering the determining or measuring frequency and/or lowering a frequency of data transmission events. Data transmission is usually particularly energy consuming. Alternatively or additionally, adapting the operation may include transmitting a message (e.g. via the transmission unit 600), the message signaling the shortage or the potential shortage in energy, e.g. to an operator, to an operating system, or to a computing device. The operator, the operating system and/or the computing device may be responsible for a plurality of devices 100 (such as to receive data from a plurality of devices 100). The devices 100 may receive different signals and/or be provided at different locations, e.g. in a power grid to monitor electricity in the power grid. The devices 100 or the inputs or ports of one device may receive signals (voltage or current signals) from the same phase or from different phases.
- one or more rectifiers (not shown). A (respective) rectifier may be positioned in the signal path between the inputs or ports P1 ... P4 and the switching unit 500 and/or in the signal path between the switching unit and the energy storage, for example.

The processing unit 300 may be configured for any one of, any arbitrarily selected plurality of, or all of the following:
- to perform or conduct measurement or determining operations associated with the signals, e.g. to determine or measure signal values at a specific time and/or synchronous for all of or some of the signals received via the inputs or ports P1 ... P4. In this way, data characteristic for the actual state or momentary state of the system can be generated and/or gathered, e.g. continuously. The data is based on the signal values which have been determined. For AC systems or signals, e.g. multi-phase alternating current systems, such as three-phase alternating current systems, the frequency with which determining or measurement operations are performed is expediently greater than the characteristic frequency or oscillation frequency of the system. The frequency for the determining operations or measurement operations (which may determine the interval separating two successive specific times) may be at least one order of magnitude or more orders of magnitude greater than a characteristic frequency of the alternating current system, e.g. the oscillating frequency of the alternating current, such as 50 Hz or 60 Hz. The time between two successive determining operations can be constant (e.g. as long as the determining operation frequency does not vary). For example, determining operations may be conducted with a frequency which is between 1 kHz and 8 kHz or between 2 kHz and 6 kHz or between 3 kHz and 6 kHz. Frequencies in these ranges have proven appropriate for DC systems or signals as well. The frequency may be 4 kHz, for example.
- to perform or conduct calculation operations. From signal values determined in the determining operation(s), e.g. at one specific time or in a time interval covering a variety of specific times (such as a time interval of 1s), data characteristic for the electric system may be calculated. The data can be based on current signal values and/or voltage signal values determined from the signals received at the inputs or ports P1 ... P4 e.g. at different times e.g. over a time interval. The calculation operation can optionally also use simulated signal values to calculate data. The simulated signal values, e.g. voltage or current signal values, can be provided by the processing unit in a simulation operation (see further below). The data may be or may comprise any one of, any arbitrarily selected plurality of or all of the following:

- active load,
- active energy,
- reactive load,
- reactive energy,
- apparent load,
- apparent energy,
- power factor,
- voltage frequency, e.g. the (e.g. momentary) oscillation frequency of the alternating voltage of an alternating current system, such as one phase of a multi-phase system,
- current frequency, e.g. the (e.g. momentary) oscillation frequency of the alternating current of an alternating current system, such as one phase of a multi-phase system.

The data may be calculated for each phase of the system.

The momentary current and/or voltage frequencies (in other words: the oscillation frequency) may vary in the electric system, i.e. the frequency may deviate from the nominal characteristic frequency the system should employ, e.g. 50 Hz or 60 Hz. Hence, the device 100 can be configured to determine the associated momentary frequency or data indicative thereof.

The data (e.g. aside from the frequencies) may be calculated using RMS-averaging (RMS: Root Mean Square) over a time interval. The frequencies may be calculated or determined by analyzing the time characteristics of the voltage or current in the time interval. The respective frequency may be determined from the time characteristic, e.g. from periodic patterns in the time characteristics of the respective signal, e.g. using the Goertzel algorithm. The time interval is expediently chosen so as to cover at least 40 oscillation cycles of the voltage or current in an alternating current system, e.g. one phase of a multi-phase alternating current system. The time interval may be 1s for example. In other words, the calculation operation frequency may be less than 10 Hz, e.g. 1Hz. Thus, the frequency with which calculation operations are performed may be less than the frequency of the determining operations.
- to perform or conduct simulation operations. The processing unit may be configured to use values or data determined or measured by the device for one portion of the electric system to simulate data or values for another portion of the electric system, expediently to characterize the system at the specific time for which the measured signal values are characteristic. For example, measurement or determining operations may be conducted for one phase of a multi-phase alternating current system, e.g. to provide measured signal values. Data for another phase of the multi-phase alternating current system may be determined based on simulated values resulting from the simulation operation based on the measured signal values. In the proposed device, a measured signal value indicative for the state of a portion of the electric system at a specific time may be used to simulate data and/or signal values indicative of another portion of the system at the specific time. Measured and/or simulated signal values may be used for the calculation operation to calculate any of the data mentioned above. Also, as an alternative or an addition to simulating values for multi-phase alternating current systems, the simulation operation may be used to consider particulars of an associated signal provider.

The device can be configured to perform simulation operations or a simulation operation is not performed, e.g. depending on how the device 100 should be used. This increases the versatility of the device.

Using a combination of measured (signal) values and simulated values to determine, e.g. calculate, characteristics of the electric system (e.g. at a specific time) can simplify the handling of the device, e.g. as some voltages do not have to be determined (which may avoid a wired connection to a conductor which always entails a risk) but can be simulated. Of course, information which usually is derivable only from a measured signal, e.g. harmonics in the voltage or the current in a different conductor than the one from which the signals were determined or measured, is not accessible via the simulated values. However, for example if voltage signal values are needed from different phases of a multi-phase alternating current system, it may be sufficient to determine or measure signal values for one of the phases and add a phase shift to determine the signal values for the other phases (at least a good approximation of the signal values for the other phases). In this case it can be assumed that the amplitudes in the phases for which the values are simulated are equal.

For calculating data characteristic for the electric system, the device may use only measured signal values, e.g. for a particular portion of the system, such as one phase, or a combination of measured and simulated values or only simulated values, e.g. for another portion of the system, such as for another phase. The data may include any one of the data mentioned above (potentially without the frequencies or with the frequencies).
- to perform or conduct signal processing or signal calculation operations. The signal processing or signal calculation operation may be performed before the (data) calculation operation for calculating the data is performed. The output of the signal processing or signal calculation operation may be used for the data calculation operation (e.g. as a measured signal value). For example, if the signal provider provides a voltage signal which should be indicative of an alternating current, e.g. in a conductor of the electric system, the signal processing or signal calculation operation may consider the associated phase shift, e.g. usually 90°, and modify the voltage signal or its values (or their time characteristic) to derive the associated current signal or its values (or their time characteristic). The modification may add a time offset corresponding to the phase shift or phase angle to the voltage signal values. The time offset may be useful in case the signal has a sinusoidal shape. In reality, the signals are usually not sinusoidal and higher harmonics of the signal carry interesting information. Hence, alternatively, the signal processing or calculation operation can time-integrate a signal, e.g. a voltage signal or the time-voltage characteristic, so as to derive the time characteristic of the signal of interest and/or its signal value, e.g. the current in the case of a Rogowski coil whose output is a voltage indicative of the change of that primary current over time. The time integration may yield the signal value or time characteristic of interest. The signal values required for the integration may be, e.g. temporarily, stored in the memory of the device. The processed signal value can be used for the data calculation.

Thus, the processing unit renders an integrator in hardware which usually has to be provided for a Rogowski coil superfluous.
- to be operatively coupled to the switching unit 500, e.g. to individually control for each input or port P1 to P4, preferably at any given time, whether the signal from that input or port should be guided or transferred to the energy harvesting unit 400 (e.g. to harvest energy therefrom) or to the processing unit 300 (e.g. for determining or measurement operations). The switching unit may be used to switch the operation of the device for each input or port (or for each signal received via an associated input or port) between an energy harvesting state in which energy is harvested and a measuring or determining state in which the determining or measurement operations for calculating data characteristic for the electric system are performed as set forth herein above. Thus, if there is a potential energy shortage, energy harvesting may be favored over providing data or signal values by the processing unit and/or over transmitting data by the transmission unit.
- to be operatively coupled to the energy monitoring unit 470 or comprise the energy monitoring unit 470. Thus, depending on the amount of energy available in the energy storage 450 or supplied by the energy harvesting unit 400, the processing unit 300 may adapt the operation of the system, e.g. as described further above.
- to be operatively coupled to the transmission unit 600. The processing unit 300 may trigger transmission events. A transmission event may comprise a data set with data characteristic for the electric system, e.g. at one specific time or over one time interval or at different specific times or over a plurality of time intervals. The processing unit may trigger transmission of data characteristic for the electric system at predefined points in time or when a predetermined number of data sets which have been calculated for a number of specific times has been stored, e.g. in the data memory. Alternatively or additionally, the processing unit may trigger a transmission event (e.g. out of turn or deviating from a regular pattern) when the data or signal values determined by the device meet certain predefined criteria, e.g. indicating a particularly high power consumption in the system, indicating a particularly high or low current or indicating a particularly high or low voltage, in each case with respect to a predefined threshold or a, preferably dynamically, determined threshold (e.g. determined by averaging over a certain time interval).

Figure 2 illustrates the device 100 as described previously used in a multi-phase alternating current system. In this embodiment, the system is a three-phase alternating current system. In such systems there are three different phases which are out of phase relative to each other, typically by 120° between the alternating currents and voltages of the phases. Each phase has a dedicated conductor. Thus, the electric system may be a typical three-phase electric power system with three lines or conductors, each carrying alternating currents and voltages (the phases being usually offset by a phase angle of 120°). Figure 2 shows the three phase conductors or lines C1 for the first phase, C2 for the second phase, and C3 for the third phase. Further, figure 2 shows the associated neutral line or conductor N. The three phases have the same nominal characteristic frequency or oscillation frequency, e.g. 50 Hz or 60 Hz and/or approximately the same amplitudes in voltage.

A signal provider 200 is assigned to each of the conductors C1 to C3. The respective signal provider may be of the following type: a Rogowski coil, a current transformer or a provider employing a shunt resistor. The types of signal provider used for the respective conductor may be identical or different. The signal provider 200 may provide signals I1 to I3, e.g. signals indicative of the momentary or instantaneous current in the associated conductor. The signals I1 to I3 may be fed to the device 100 via inputs or ports P1 to P3 (e.g. one signal per port). Signal I1 is received by the device via P1, the signal I2 is received by the device via P2, the signal I3 is received by the device via P3. Signals I1 to I3 may be voltage signals (e.g. for shunt resistors or Rogowski coils) or current signals (e.g. for current transformers). The input or port P4 can be used to receive a voltage signal U1 indicative of a phase voltage in C1 (i.e. of the voltage between C1 and N). The voltage signal U1 may be obtained via a voltage divider, for example. The voltage U1 (i.e. the alternating voltage of the first phase) can advantageously be used to directly supply power to the device, e.g. in a manner controlled by the switching unit 500 and/or the processing unit 300. The switching unit 500 and/or the processing unit 300 can be operable to selectively draw power from the voltage providing the voltage signal (U1 in this embodiment), e.g. if (preferably only if) the harvested energy from other signals is not sufficient for operating the device. Hence, energy harvested by the device from the signals I1 to I3 may not be absolutely necessary to operate the device 100 (although the device may be operable with harvested energy only). Nevertheless, energy may be harvested and stored in the device 100, e.g. to provide an energy backup supply in case there is no longer power supplied or suppliable directly via U1. The device may use the energy stored in the energy storage to send a message indicating the potential energy shortage to a receiver, e.g. to a gateway, and/or use the energy stored in the device to temporarily provide energy for the operation of the device. However, as harvested energy may not be necessary for operation of the device (owing to the optional direct power supply via U1), signals can be fed to the device and be processed therein which are not particularly suitable for energy harvesting. Current signals (e.g. provided via a current transformer) usually are suitable for energy harvesting, whereas voltage signals (e.g. provided via a Rogowski coil) usually are not as suitable.

In the depicted setting, the device 100 can monitor the currents in C1 to C3 via the signals I1 to I3, where the momentary values of the current can be determined or measured by the processing unit 300, e.g. with a frequency of 4kHz, based on the signals provided by the signal providers 200 (if Rogowski coils are used, the processing unit may process the signal to provide the current signal indicative of the current to provide the current signal of interest). Hence, the momentary current can be monitored by the device for each of the three phases. Via the signal U1, the momentary voltage in the conductor C1 can be determined. The determining frequency may be identical for all signals reaching the processing unit from different ports at a specific time. The determining frequency may be lowered or raised by the processing unit, e.g. to reduce energy consumption or to shorten or lengthen the time interval with which signal values are measured or determined.

The time-voltage characteristic of the voltage U1 (i.e. how the voltage U1 at conductor C1 changes with time) can be determined via the measured voltage signal values. The time-voltage characteristic of the voltages U2 and U3 (in each case relative to the neutral line N) of the other phases can be simulated. For example, U2 can be simulated by adding a time offset corresponding to a phase offset, e.g. of 120°, to the time-voltage characteristic for U1 (which shifts the time-voltage characteristic of U1 by a time offset corresponding to the phase offset) in order to provide the time-voltage characteristic for U2 (and thereby the value at the specific time). For example, U3 can be simulated by adding a time offset corresponding to a phase offset (different to the one for U2), e.g. 240°, to the time-voltage characteristic for U1 (which shifts the time-voltage characteristic of U1 by a time offset corresponding to the phase offset) in order to provide the time-voltage characteristic for U3 (and thereby the value at the specific time). The respective simulation is expediently performed by firmware or software stored in the device, e.g. in the processing unit and/or in the program memory.

The time offset corresponding to the phase offset added to U1 may be constant, e.g. one constant offset for simulating U2 and another constant offset for simulating U3. In this case, the time offset may be 120° at the nominal characteristic frequency of e.g. 50 Hz or 60Hz (one oscillation cycle at the nominal characteristic frequency corresponding to 360°) for U2 (assuming that U2 is the second phase successive to U1) and 240° at the nominal characteristic frequency for U3 (which is the third phase which is successive to U2). The phase offset of 120° is the usual phase angle offset between two different successive phases in a three-phase alternating current system. Thus, the simulated time-voltage characteristic may have the same momentary values as the time-voltage characteristic determined from the measured (signal) values albeit phase-shifted. Also, the higher harmonics may be identical (albeit shifted).

This simulation may already be sufficient to provide simulated signal values (e.g. voltage values) to calculate data (together with the measured values of U1, I1, I2 and/or I3) which characterizes the three-phase alternating current system well, e.g. each phase of the system. The data which is calculated can be the data described above. The data may be transmitted in data sets, e.g. in bundles of data sets (where each data set may comprise data characterizing the electric system and (optionally) time information indicating the time at or for which the data in the data set was determined).

The current and/or voltage frequency in a power grid (though it should have a constant nominal value, e.g. 50 or 60 Hz) may vary, e.g. depending on the load in the grid. For example the momentary frequency may be lower, e.g. 49.5 Hz, or higher, e.g. 50.5 Hz, than the nominal (characteristic) frequency. Hence, instead of using the constant time offset as described above, the time offset for the simulation may be dynamically determined, e.g. based on the momentary characteristic frequency. The momentary characteristic frequency can be determined based on measured or determined signal values (e.g. the current signal values or voltage signal values), e.g. based on the voltage signal values of U1. The processing unit may take a representative portion of the time-voltage characteristic of the first voltage U1 as the time-voltage characteristic which is used to determine the momentary characteristic frequency. The determined frequency may be used to determine the time offset from the phase offset. The time-voltage characteristic used for the frequency determination may be formed by the first voltage signal values determined directly before the offset is determined. The representative portion may have a length of one oscillation cycle or more than one cycle. The momentary frequency can be determined from that portion, e.g. by averaging if more than one cycle is used. If the momentary frequency, e.g. the voltage frequency determined from the time-voltage characteristic of U1 (i.e. a time-voltage characteristic based on measured values), is less than the nominal frequency, the time offset for shifting the time-voltage characteristic of U1 to simulate or provide the time-voltage characteristic of U2 or U3 may be increased by an amount determined by the deviation of the momentary frequency from the nominal frequency. If the momentary frequency is higher than the nominal frequency the time offset may be reduced by an amount determined by the deviation of the momentary frequency from the nominal frequency. The determined momentary frequency may be assumed to be identical for all phases.

Thus, the momentary characteristic frequency may be derived, e.g. calculated, from a known time-voltage characteristic (e.g. based on values stored in the device from previous measurements or determining operations). The momentary characteristic frequency may be calculated using a Fourier transform, e.g. a discrete Fourier transform (DFT).

In some embodiments, the momentary characteristic frequency may be determined by an algorithm, e.g. by the Goertzel algorithm. This algorithm is particularly efficient with respect to energy consumption. The algorithm may be implemented in firmware or software. The algorithm can preferably be performed by the processing unit.The Goertzel algorithm is a method for frequency analysis of digital signals. It is an efficient method for calculating individual components of a Discrete Fourier Transform (DFT), which is particularly useful when only a small portion of the spectrum is required. If one wants to achieve precise frequency determination, e.g. in the 1/10 Hz range, with few measurement points, the Goertzel algorithm offers several remarkable advantages, e.g.:
1. Resource Optimization: The Goertzel algorithm is able to extract a selected frequency from a given signal without the need to compute the entire frequency spectrum, as would be the case with a full DFT. This results in a significant saving of computational resources and makes the algorithm particularly suitable for applications with limited resources or when data must be analyzed in real time.
2. Accuracy: Despite the small number of measurement points, the Goertzel algorithm can determine frequencies with high accuracy. This feature is especially important in applications where high frequency resolution is required, e.g. 0.1 Hz.
3. Flexibility: The Goertzel algorithm can be configured to focus on any frequency range. Compared to the Fast Fourier Transform (FFT), which is limited to equal spacing between the analyzed frequencies, the Goertzel algorithm can be directed to any frequency of interest, whether it is a uniform distribution or not.
4. Robustness to Frequency Shifts: Unlike some other frequency determination methods, the Goertzel algorithm is less susceptible to problems that can arise from frequency shifts.

In summary, the Goertzel algorithm is an efficient, accurate, and flexible frequency analysis tool that is ideally suited for applications with limited measurement points and high frequency resolution requirements.

Simulating the time-voltage characteristic (or the associated voltage signal values) of one or more phases based on the measured time-voltage characteristic (or measured voltage signal values) of another phase, e.g. as in the solution described above in connection with figure 2, is advantageous. For example, the user of the device, e.g. an electrician, does not have to temper with voltages of more than one phase. Putting the device to use is easy and less risky as contact connection does not have to be made to the voltages which are simulated, e.g. a standard wall outlet may be sufficient to provide the time-voltage characteristic of U1.

Alternatively or additionally to simulating the situation in another phase, in case the signal provider 200 connected or to be connected with one or more of the inputs or ports P1 to P3 provides a voltage signal indicative of a current, such as a Rogowski coil, the processing unit 300 may be configured to derive, e.g. calculate, the corresponding current signal value based on the voltage signal value, e.g. by adding a time corresponding to a 90° phase shift (at the nominal characteristic frequency or the momentary frequency) to the associated time-voltage characteristic or by integrating the time-voltage characteristic in the processing unit. Hence, a separate integrator is not needed in the proposed setting.

We note that figure 2 merely gives one example of how the proposed device 100 can be put to use. Other uses are possible, such as, for example, providing signals indicative of the current at three different locations of a selected phase, e.g. one of the three phases, to inputs or ports P1 to P3 along with the associated phase voltage to the remaining input or port P4. In this case, a simulation operation may not be needed. However, the device may nevertheless be configured to be able to perform a simulation operation (if it were used in a setting where the simulation might be beneficial).

The device 100 can be easily placed at different locations in an electric system, such as a power grid and generate data characteristic for the system at this location. The data can be transmitted to and collected by a further electronic device, e.g. by a computing device or server.

The device 100 may be a portable and/or mobile device which is installed or mounted close to that location in the electric system which should be monitored with the device.

The device may be configured such that the power consumption, e.g. the average power consumption, is less than 0.25 mW and/or greater than 0.1 mW per input or port of the device. Alternatively or additionally, the total average power consumption of the device during its operation may be less than 1 mW (e.g. if the device 100 with four inputs operates as described further above, particularly with a frequency of transmission events of less than or equal to one transmission event per minute) and/or greater than 0.3 mW.

The device is expediently configured such that the determining operation, the simulation operation, and/or the calculation operation is carried out to provide signal values and/or data characteristic for the system at different times to enable a time-resolved monitoring of the multi-phase alternating current system. Each phase of the system may be monitored, e.g. only one phase or more than one phase. The frequency with which the respective operations are performed may be equal or different. Transmission events may be performed at a lower frequency than calculation operations. Simulation operations may be performed at the same frequency as the determining operation or as the calculation operation.

In any given application setting of the device, not all of the inputs or ports have to be provided with signals for the device to work (e.g. only one input or port can be provided with a signal or only two inputs or ports or only three inputs or ports) but all inputs or ports can be provided with signals of course.

The scope of protection is not limited to the examples given herein above but is defined by the appended set of claims.

### Reference numerals

- 100: device
- 110: housing
- 112: interior
- 120: conductor carrier

- 200: signal provider

- 300: processing unit
- 350: memory
- 350a: data memory
- 350b: program memory

- 400: energy harvesting unit
- 450: energy storage unit
- 470: energy monitoring unit

- 500: switching unit

- 600: transmission unit

- P1...P4: input
- S1...S4: signal
- I1...I3: signal
- U1: signal

## Claims

1. A device (100) for an electric system, the device comprising:
a plurality of signal inputs (P1, P2, P3, P4), wherein each signal input of the plurality of signal inputs is configured to receive a signal associated with the electric system and indicative of the momentary state of the electric system at a specific time, and
a processing unit (300), wherein
the processing unit is configured to perform a determining operation, wherein,
in the determining operation, a signal value of the signal received at one of, more of or all of the signal inputs is determined, e.g. measured, the determined signal value being indicative of the momentary state of the electric system at the specific time, wherein
the electric system is a multi-phase alternating current system, and wherein the processing unit is configured to perform a simulation operation which uses the signal value determined by the processing unit, the signal value being indicative of the momentary state of one phase of the multi-phase alternating current system at the specific time, and wherein the signal value is used to simulate a signal value indicative of the momentary state of another phase of the multi-phase alternating current system at the specific time, wherein
the device comprises an energy harvesting unit (400) which is configured to harvest electrical energy, wherein
the device comprises a switching unit (500),
the switching unit being operable to switch transfer of signals received by the device via the plurality of inputs between the processing unit and the energy harvesting unit or a combination of both, wherein
the switching unit is configured such that signals received via each input can be switched independently between the processing unit and the energy harvesting unit or a combination of both, and wherein
the device has an energy storage unit (450) configured to store harvested energy

2. The device of claim 1, wherein the device comprises:
a first signal input of the plurality of signal inputs, the first signal input being configured to receive a first signal indicative of a momentary first current of a first phase of a multi-phase alternating current in a first conductor,
a second signal input of the plurality of signal inputs, the second signal input being configured to receive a second signal indicative of a momentary second current of a second phase of the multi-phase alternating current in a second conductor,
a voltage signal input of the plurality of signal inputs, the voltage signal input being configured to receive a voltage signal indicative of a momentary first voltage of the first phase of the multi-phase alternating current at the first conductor, wherein,
in the determining operation,
a first voltage signal value is determined, e.g. measured, the first voltage signal value
being indicative of the voltage signal at the specific time, and wherein
the processing unit is configured to perform
a simulation operation, wherein, in the simulation operation, a second voltage signal value is simulated, the second voltage signal value being indicative of a momentary second voltage of the second phase of the multi-phase alternating current at the specific time at the second conductor, wherein the second voltage signal value is simulated based on the first voltage signal value at the specific time.

3. The device of claim 2, wherein the device further comprises a third signal input of the plurality of signal inputs, the third signal input being configured to receive a third signal indicative of a momentary third current of a third phase of a multi-phase alternating current in a third conductor, wherein,
in the simulation operation, a third voltage signal value is simulated, the third voltage signal value being indicative of a momentary third voltage of the third phase of the multi-phase alternating current at the specific time at the third conductor, wherein the third voltage value is simulated based on the first voltage value at the specific time.

4. The device of claim 2 or 3, wherein simulating the second voltage signal value comprises using a time-voltage characteristic of the first voltage and shifting the time-voltage characteristic by an offset.

5. The device of claims 3 and 4, wherein simulating the third voltage signal value comprises using the time-voltage characteristic of the first voltage and shifting the time-voltage characteristic by another offset.

6. The device of claim 4 or 5, wherein the time-voltage characteristic of the first voltage is based on a plurality of first voltage signal values previously determined by the processing unit.

7. The device of any one of the preceding claims 4 to 6, wherein the offset is determined by the phase offset between the first phase and the second phase of the multi-phase alternating current and/or wherein the other offset is determined by the phase offset between the first phase and the third phase of the multi-phase alternating current, and/or wherein the device is configured to dynamically determine the offset or the other offset based on the time-voltage characteristic of the first voltage and/or based on a first voltage frequency characteristic for the first voltage.

8. The device of any one of the preceding claims, wherein the device is configured to perform the determining operation with a determining frequency, and wherein the determining frequency is between 1 kHz and 7 kHz or between 2 kHz and 6 kHz.

9. The device of any one of the preceding claims, wherein the plurality of signal inputs, e.g. the first signal input, the second signal input and/or the third signal input, are configured to receive signals from signal providers (200)
coupleable or coupled to the inputs of the plurality of inputs, the
signal provided by the respective signal provider to the associated input being one of:
- voltage signals indicative of a current,
- voltage signals indicative of a voltage,
- current signals indicative of a current,
- analog signals,
- DC signals,
- AC signals, and
wherein the respective signal provider is or comprises one of:
- a current transformer,
- a Rogowski coil,
- a shunt resistor.

10. The device of any one of the preceding claims, wherein the processing unit is configured to perform a calculation operation, wherein, in the calculation operation, data characteristic for the electric system is calculated, wherein the data characteristic for the multi-phase alternating current system, e.g. at the specific time, comprises
a) data calculated only based on one or more signal values determined in the determining operation and/or
b) data calculated based on one or more signal values determined in the determining operation and one or more signal values simulated in the simulation operation, and optionally, wherein,
the data characteristic for the multi-phase alternating current system comprises any one of, any arbitrarily selected plurality of or all of:
- active load,
- active energy,
- reactive load,
- reactive energy,
- apparent load,
- apparent energy,
- power factor,
- voltage frequency,
- current frequency.

11. The device of any one of the preceding claims, wherein the device has a device housing (110), the device housing defining the exterior of the device, wherein the device housing has an interior (112), wherein a volume of the interior is less than or equal to 100 cm³ and/or greater than or equal to 10 cm³.

12. The device of any one of the preceding claims, wherein the device has an average power consumption of less than or equal to 1 mW.

13. The device of any one of the preceding claims, wherein the device comprises a wireless transmission unit (600), the wireless transmission unit being operable to transmit data characteristic for the electric system, e.g. to a gateway.

14. The device of any one of the preceding claims, wherein the device has an energy monitoring unit (470), wherein the energy monitoring unit is configured to monitor whether
i) sufficient energy is provided via the energy harvesting unit and/or
ii) sufficient energy is stored in the energy storage unit
to continue operation of the device, e.g. of the processing unit and/or of the transmission unit, and wherein, if the energy monitoring unit detects that insufficient energy is provided and/or stored, the device is configured to adapt its operation to reduce energy consumption, e.g. by lowering the determining frequency or a frequency of data transmission events, and/or to transmit a message signaling the shortage or the potential shortage in energy.

## Patentansprüche

1. Vorrichtung (100) für ein elektrisches System, wobei die Vorrichtung Folgendes umfasst:
eine Mehrzahl von Signaleingängen (P1, P2, P3, P4), wobei jeder Signaleingang aus der Mehrzahl von Signaleingängen konfiguriert ist, um ein Signal zu empfangen, das mit dem elektrischen System assoziiert ist und den momentanen Zustand des elektrischen Systems zu einer spezifischen Zeit angibt, und
eine Verarbeitungseinheit (300), wobei die Verarbeitungseinheit konfiguriert ist, um einen Bestimmungsvorgang durchzuführen, wobei
in dem Bestimmungsvorgang ein Signalwert des an einem der, mehreren der oder allen der Signaleingänge empfangenen Signals bestimmt, z. B. gemessen wird, wobei der bestimmte Signalwert den momentanen Zustand des elektrischen Systems zu der spezifischen Zeit angibt, wobei
das elektrische System ein mehrphasiges Wechselstromsystem ist, und wobei die Verarbeitungseinheit konfiguriert ist, um einen Simulationsvorgang durchzuführen, der den Signalwert verwendet, der durch die Verarbeitungseinheit bestimmt wird, wobei der Signalwert den momentanen Zustand einer Phase des mehrphasigen Wechselstromsystems zu der spezifischen Zeit angibt, und wobei der Signalwert verwendet wird, um einen Signalwert zu simulieren, der den momentanen Zustand einer anderen Phase des mehrphasigen Wechselstromsystems zu der spezifischen Zeit angibt, wobei
die Vorrichtung eine Energiegewinnungseinheit (400) umfasst, die konfiguriert ist, um elektrische Energie zu gewinnen, wobei
die Vorrichtung eine Schalteinheit (500) umfasst, wobei die Schalteinheit betriebsfähig ist, Übertragung von Signalen, die durch die Vorrichtung über die Mehrzahl von Eingängen empfangen werden, zwischen der Verarbeitungseinheit und der Energiegewinnungseinheit oder einer Kombination aus beiden zu schalten, wobei
die Schalteinheit konfiguriert ist, sodass Signale, die über jeden Eingang empfangen werden, unabhängig zwischen der Verarbeitungseinheit und der Energiegewinnungseinheit oder einer Kombination aus beiden geschaltet werden können, und wobei
die Vorrichtung eine Energiespeichereinheit (450) aufweist, die konfiguriert ist, um gewonnene Energie zu speichern.

2. Vorrichtung nach Anspruch 1, wobei die Vorrichtung Folgendes umfasst:
einen ersten Signaleingang aus der Mehrzahl von Signaleingängen, wobei der erste Signaleingang konfiguriert ist, um ein erstes Signal zu empfangen, das einen momentanen ersten Strom einer ersten Phase eines mehrphasigen Wechselstroms in einem ersten Leiter angibt,
einen zweiten Signaleingang aus der Mehrzahl von Signaleingängen, wobei der zweite Signaleingang konfiguriert ist, um ein zweites Signal zu empfangen, das einen momentanen zweiten Strom einer zweiten Phase des mehrphasigen Wechselstroms in einem zweiten Leiter angibt,
einen Spannungssignaleingang aus der Mehrzahl von Signaleingängen, wobei der Spannungssignaleingang konfiguriert ist, um ein Spannungssignal zu empfangen, das eine momentane erste Spannung der ersten Phase des mehrphasigen Wechselstroms an dem ersten Leiter angibt, wobei
in dem Bestimmungsvorgang
ein erster Spannungssignalwert bestimmt, z. B. gemessen wird, wobei der erste Spannungssignalwert das Spannungssignal zu der spezifischen Zeit angibt, und wobei
die Verarbeitungseinheit konfiguriert ist, um
einen Simulationsvorgang durchzuführen, wobei in dem Simulationsvorgang ein zweiter Spannungssignalwert simuliert wird, wobei der zweite Spannungssignalwert eine momentane zweite Spannung der zweiten Phase des mehrphasigen Wechselstroms zu der spezifischen Zeit an dem zweiten Leiter angibt, wobei der zweite Spannungssignalwert basierend auf dem ersten Spannungssignalwert zu der spezifischen Zeit simuliert wird.

3. Vorrichtung nach Anspruch 2, wobei die Vorrichtung ferner einen dritten Signaleingang aus der Mehrzahl von Signaleingängen umfasst, wobei der dritte Signaleingang konfiguriert ist, um ein drittes Signal zu empfangen, das einen momentanen dritten Strom einer dritten Phase eines mehrphasigen Wechselstroms in einem dritten Leiter angibt, wobei
in dem Simulationsvorgang ein dritter Spannungssignalwert simuliert wird, wobei der dritte Spannungssignalwert eine momentane dritte Spannung der dritten Phase des mehrphasigen Wechselstroms zu der spezifischen Zeit an dem dritten Leiter angibt, wobei der dritte Spannungswert basierend auf dem ersten Spannungswert zu der spezifischen Zeit simuliert wird.

4. Vorrichtung nach Anspruch 2 oder 3, wobei das Simulieren des zweiten Spannungssignalwertes eine Verwendung einer Zeit-Spannungs-Charakteristik der ersten Spannung und eine Verschiebung der Zeit-Spannungs-Charakteristik um einen Versatz umfasst.

5. Vorrichtung nach Anspruch 3 und 4, wobei das Simulieren des dritten Spannungssignalwertes die Verwendung der Zeit-Spannungs-Charakteristik der ersten Spannung und die Verschiebung der Zeit-Spannungs-Charakteristik um einen anderen Versatz umfasst.

6. Vorrichtung nach Anspruch 4 oder 5, wobei die Zeit-Spannungs-Charakteristik der ersten Spannung auf einer Mehrzahl von ersten Spannungssignalwerten basiert, die zuvor durch die Verarbeitungseinheit bestimmt wurden.

7. Vorrichtung nach einem der vorhergehenden Ansprüche 4 bis 6, wobei der Versatz durch den Phasenversatz zwischen der ersten Phase und der zweiten Phase des mehrphasigen Wechselstroms bestimmt wird und/oder wobei der andere Versatz durch den Phasenversatz zwischen der ersten Phase und der dritten Phase des mehrphasigen Wechselstroms bestimmt wird, und/oder
wobei die Vorrichtung konfiguriert ist, um den Versatz oder den anderen Versatz basierend auf der Zeit-Spannungs-Charakteristik der ersten Spannung und/oder basierend auf einer ersten Spannungsfrequenz-Charakteristik für die erste Spannung dynamisch zu bestimmen.

8. Vorrichtung nach einem der vorhergehenden Ansprüche, wobei die Vorrichtung konfiguriert ist, um den Bestimmungsvorgang mit einer Bestimmungsfrequenz durchzuführen, und wobei die Bestimmungsfrequenz zwischen 1 kHz und 7 kHz oder zwischen 2 kHz und 6 kHz ist.

9. Vorrichtung nach einem der vorhergehenden Ansprüche, wobei die Mehrzahl von Signaleingängen, z. B. der erste Signaleingang, der zweite Signaleingang und/oder der dritte Signaleingang, konfiguriert ist, um Signale von Signalbereitstellern (200) zu empfangen, die an die Eingänge aus der Mehrzahl von Eingängen koppelbar oder gekoppelt sind, wobei das Signal, das durch den jeweiligen Signalbereitsteller an den assoziierten Eingang bereitgestellt wird, eines der Folgenden ist:
- Spannungssignale, die einen Strom angeben,
- Spannungssignale, die eine Spannung angeben,
- Stromsignale, die einen Strom angeben,
- analoge Signale,
- Gleichstrom-Signale,
- Wechselstrom-Signale, und
wobei der jeweilige Signalbereitsteller eines von Folgendem ist oder umfasst:
- ein Stromwandler,
- eine Rogowski-Spule,
- ein Nebenschlusswiderstand.

10. Vorrichtung nach einem der vorhergehenden Ansprüche, wobei die Verarbeitungseinheit konfiguriert ist, um einen Berechnungsvorgang durchzuführen, wobei, in dem Berechnungsvorgang, Daten berechnet werden, die für das elektrische System charakteristisch sind, , wobei die Daten, die für das mehrphasige Wechselstromsystem charakteristisch sind, z. B. zu der spezifischen Zeit, Folgendes umfassen:
a) Daten, die nur basierend auf einem oder mehreren Signalwerten berechnet werden, die in dem Bestimmungsvorgang bestimmt werden, und/oder
b) Daten, die basierend auf einem oder mehreren Signalwerten, die in dem Bestimmungsvorgang bestimmt werden, und einem oder mehreren Signalwerten, die in dem Simulationsvorgang simuliert werden, berechnet werden, und wobei optional
die Daten, die für das mehrphasige Wechselstromsystem charakteristisch sind, ein beliebiges von, eine beliebige willkürlich ausgewählte Mehrzahl von oder alles von Folgendem umfassen:
- aktive Last,
- aktive Energie,
- reaktive Last,
- reaktive Energie,
- Scheinlast,
- Scheinenergie,
- Leistungsfaktor,
- Spannungsfrequenz,
- Stromfrequenz.

11. Vorrichtung nach einem der vorhergehenden Ansprüche, wobei die Vorrichtung ein Vorrichtungsgehäuse (110) aufweist, wobei das Vorrichtungsgehäuse das Äußere der Vorrichtung definiert, wobei das Vorrichtungsgehäuse einen Innenraum (112) aufweist, wobei ein Volumen des Innenraumes kleiner als oder gleich 100 cm³ und/oder größer als oder gleich 10 cm³ ist.

12. Vorrichtung nach einem der vorhergehenden Ansprüche, wobei die Vorrichtung einen durchschnittlichen Leistungsverbrauch von kleiner als oder gleich 1 mW aufweist.

13. Vorrichtung nach einem der vorhergehenden Ansprüche, wobei die Vorrichtung eine drahtlose Übertragungseinheit (600) umfasst, wobei die drahtlose Übertragungseinheit betriebsfähig ist, um Daten zu übertragen, die für das elektrische System charakteristisch sind, z. B. zu einem Gateway.

14. Vorrichtung nach einem der vorhergehenden Ansprüche, wobei die Vorrichtung eine Energieüberwachungseinheit (470) aufweist,
wobei die Energieüberwachungseinheit konfiguriert ist, um zu überwachen, ob
i) ausreichend Energie über die Energiegewinnungseinheit bereitgestellt wird, und/oder
ii) ausreichend Energie in der Energiespeichereinheit gespeichert ist,
um Betrieb der Vorrichtung, z. B. der Verarbeitungseinheit und/oder der Übertragungseinheit, fortzusetzen, und wobei, wenn die Energieüberwachungseinheit erfasst, dass unzureichend Energie bereitgestellt und/oder gespeichert ist, die Vorrichtung konfiguriert ist, um ihren Betrieb anzupassen, um Energieverbrauch zu reduzieren, z. B. durch Senken der Bestimmungsfrequenz oder einer Frequenz von Datenübertragungsereignissen, und/oder um eine Nachricht zu übertragen, die den Mangel oder den potentiellen Mangel an Energie signalisiert.

## Revendications

1. Dispositif (100) destiné à un système électrique, le dispositif comprenant :
une pluralité d'entrées de signal (P1, P2, P3, P4), chaque entrée de signal de la pluralité d'entrées de signal étant configurée pour recevoir un signal associé au système électrique et indiquant l'état momentané du système électrique à un moment spécifique, et
une unité de traitement (300), ladite unité de traitement étant configurée pour réaliser une opération de détermination,
lors de l'opération de détermination, une valeur de signal du signal reçu au niveau d'une, de plusieurs ou de toutes les entrées de signal étant déterminée, p. ex. mesurée, la valeur de signal déterminée indiquant l'état momentané du système électrique au moment spécifique,
ledit système électrique étant un système à courant alternatif polyphasé, et ladite unité de traitement étant configurée pour réaliser une opération de simulation qui utilise la valeur de signal déterminée par l'unité de traitement, la valeur de signal indiquant l'état momentané d'une phase du système à courant alternatif polyphasé au moment spécifique, et ladite valeur de signal étant utilisée pour simuler une valeur de signal indiquant l'état momentané d'une autre phase du système à courant alternatif polyphasé au moment spécifique,
ledit dispositif comprenant une unité de récupération d'énergie (400) qui est configurée pour récupérer de l'énergie électrique,
ledit dispositif comprenant une unité de commutation (500), l'unité de commutation étant fonctionnelle pour commuter le transfert de signaux reçus par le dispositif par l'intermédiaire de la pluralité d'entrées entre l'unité de traitement et l'unité de récupération d'énergie ou une combinaison des deux,
ladite unité de commutation étant configurée de sorte que les signaux reçus par l'intermédiaire de chaque entrée puissent être commutés indépendamment entre l'unité de traitement et l'unité de récupération d'énergie ou une combinaison des deux, et
le dispositif comportant une unité de stockage d'énergie (450) configurée pour stocker l'énergie récupérée.

2. Dispositif selon la revendication 1, ledit dispositif comprenant :
une première entrée de signal de la pluralité d'entrées de signal, la première entrée de signal étant configurée pour recevoir un premier signal indiquant un premier courant momentané d'une première phase d'un courant alternatif polyphasé dans un premier conducteur,
une deuxième entrée de signal de la pluralité d'entrées de signal, la deuxième entrée de signal étant configurée pour recevoir un deuxième signal indiquant un deuxième courant momentané d'une deuxième phase du courant alternatif polyphasé dans un deuxième conducteur,
une entrée de signal de tension de la pluralité d'entrées de signal, l'entrée de signal de tension étant configurée pour recevoir un signal de tension indiquant une première tension momentanée de la première phase du courant alternatif polyphasé au niveau du premier conducteur,
lors de l'opération de détermination,
une première valeur de signal de tension étant déterminée, p. ex. mesurée, la première valeur de signal de tension indiquant le signal de tension au moment spécifique, et
ladite unité de traitement étant configurée pour réaliser
une opération de simulation, lors de l'opération de simulation, une deuxième valeur de signal de tension étant simulée, la deuxième valeur de signal de tension indiquant une deuxième tension momentanée de la deuxième phase du courant alternatif polyphasé au moment spécifique au niveau du deuxième conducteur, ladite deuxième valeur de signal de tension étant simulée sur la base de la première valeur de signal de tension au moment spécifique.

3. Dispositif selon la revendication 2, ledit dispositif comprenant en outre une troisième entrée de signal de la pluralité d'entrées de signal, la troisième entrée de signal étant configurée pour recevoir un troisième signal indiquant un troisième courant momentané d'une troisième phase d'un courant alternatif polyphasé dans un troisième conducteur,
lors de l'opération de simulation, une troisième valeur de signal de tension étant simulée, la troisième valeur de signal de tension indiquant une troisième tension momentanée de la troisième phase du courant alternatif polyphasé au moment spécifique au niveau du troisième conducteur, ladite troisième valeur de signal de tension étant simulée sur la base de la première valeur de tension au moment spécifique.

4. Dispositif selon la revendication 2 ou 3, ladite simulation de la deuxième valeur de signal de tension comprenant l'utilisation d'une caractéristique temps-tension de la première tension et le décalage de la caractéristique temps-tension d'un certain décalage.

5. Dispositif selon les revendications 3 et 4, ladite simulation de la troisième valeur de signal de tension comprenant l'utilisation de la caractéristique temps-tension de la première tension et le décalage de la caractéristique temps-tension d'un autre décalage.

6. Dispositif selon la revendication 4 ou 5, ladite caractéristique temps-tension de la première tension étant basée sur une pluralité de premières valeurs de signal de tension précédemment déterminées par l'unité de traitement.

7. Dispositif selon l'une quelconque des revendications précédentes 4 à 6, ledit décalage étant déterminé par le décalage de phase entre la première phase et la deuxième phase du courant alternatif polyphasé, et/ou ledit autre décalage étant déterminé par le décalage de phase entre la première phase et la troisième phase du courant alternatif polyphasé, et/ou ledit dispositif étant configuré pour déterminer dynamiquement le décalage ou l'autre décalage sur la base de la caractéristique temps-tension de la première tension et/ou sur la base d'une première caractéristique tension-fréquence pour la première tension.

8. Dispositif selon l'une quelconque des revendications précédentes, ledit dispositif étant configuré pour réaliser l'opération de détermination avec une fréquence de détermination, et ladite fréquence de détermination étant comprise entre 1 kHz et 7 kHz ou entre 2 kHz et 6 kHz.

9. Dispositif selon l'une quelconque des revendications précédentes, ladite pluralité d'entrées de signaux, p. ex. la première entrée de signal, la deuxième entrée de signal et/ou la troisième entrée de signal, étant configurées pour recevoir des signaux en provenance de fournisseurs de signaux (200) pouvant être couplés ou étant couplés aux entrées de la pluralité d'entrées, le signal fourni par le fournisseur de signaux respectif à l'entrée associée étant l'un parmi :
- des signaux de tension indiquant un courant,
- des signaux de tension indiquant une tension,
- des signaux de courant indiquant un courant,
- des signaux analogiques,
- des signaux CC,
- des signaux CA, et
ledit fournisseur de signaux respectif étant ou comprenant l'un des suivants :
- un transformateur de courant,
- une bobine de Rogowski,
- une résistance shunt.

10. Dispositif selon l'une quelconque des revendications précédentes, ladite unité de traitement étant configurée pour réaliser une opération de calcul, une caractéristique de données étant calculée lors de l'opération de calcul pour le système électrique, ladite caractéristique de données pour le système de courant alternatif polyphasé, p. ex. au moment spécifique, comprenant
a) des données calculées uniquement sur la base d'une ou plusieurs valeurs de signal déterminées lors de l'opération de détermination et/ou
b) des données calculées sur la base d'une ou plusieurs valeurs de signal déterminées lors de l'opération de détermination et d'une ou plusieurs valeurs de signal simulées lors de l'opération de simulation, la caractéristique de données pour le système de courant alternatif polyphasé comprenant éventuellement un élément quelconque, une pluralité quelconque d'éléments sélectionnés arbitrairement ou la totalité des éléments parmi :
- une charge active,
- une énergie active,
- une charge réactive,
- une énergie réactive,
- une charge apparente,
- une énergie apparente,
- un facteur de puissance,
- une fréquence de tension,
- une fréquence de courant.

11. Dispositif selon l'une quelconque des revendications précédentes, ledit dispositif comportant un boîtier de dispositif (110), ledit boîtier de dispositif définissant l'extérieur du dispositif, ledit boîtier de dispositif comportant un intérieur (112), un volume de l'intérieur étant inférieur ou égal à 100 cm³ et/ou supérieur ou égal à 10 cm³.

12. Dispositif selon l'une quelconque des revendications précédentes, ledit dispositif comportant une consommation de puissance moyenne inférieure ou égale à 1 mW.

13. Dispositif selon l'une quelconque des revendications précédentes, ledit dispositif comprenant une unité de transmission sans fil (600), l'unité de transmission sans fil étant fonctionnelle pour transmettre une caractéristique de données pour le système électrique, p. ex. à une passerelle.

14. Dispositif selon l'une quelconque des revendications précédentes, ledit dispositif comportant une unité de surveillance d'énergie (470), ladite unité de surveillance d'énergie étant configurée pour surveiller si
i) une énergie suffisante est fournie par l'intermédiaire de l'unité de récupération d'énergie et/ou
ii) une énergie suffisante est stockée dans l'unité de stockage d'énergie
pour poursuivre le fonctionnement du dispositif, p. ex. de l'unité de traitement et/ou de l'unité de transmission, et si l'unité de surveillance d'énergie détecte qu'une énergie insuffisante est fournie et/ou stockée, ledit dispositif étant configuré pour adapter son fonctionnement pour réduire une consommation d'énergie, p. ex. en abaissant la fréquence de détermination ou une fréquence d'événements de transmission de données, et/ou pour transmettre un message signalant la pénurie ou la pénurie potentielle d'énergie.
